# EUROPÄISCHE PATENTSCHRIFT

(11) **EP 0 893 011 B1**
(45) Veröffentlichungstag und Bekanntmachung des Hinweises auf die Patenterteilung: **01.12.1999**
(21) Anmeldenummer: 97902247.2
(22) Anmeldetag: 28.01.1997
(51) Int. Cl.: H03L 7/107

(54) **PHASENREGELSCHLEIFE MIT UMSCHALTBARER SCHLEIFENBANDBREITE**
PHASE-LOCKED LOOP SWITCHABLE BETWEEN A HIGH AND A LOW BANDWIDTH
BOUCLE ASSERVIE EN PHASE AVEC LARGEUR DE BANDE COMMUTABLE

(30) Priorität: 21.03.1996 DE 19611219
(43) Veröffentlichungstag der Anmeldung: 27.01.1999
(73) Patentinhaber: FRAUNHOFER-GESELLSCHAFT ZUR FÖRDERUNG DER ANGEWANDTEN FORSCHUNG E.V., 80636 München (DE)
(72) Erfinder: PERTHOLD, Rainer, D-91052 Erlangen (DE); LASKE, Christopher, D-92224 Amberg (DE); GERHÄUSER, Heinz, D-91344 Waischenfeld (DE)
(74) Vertreter: Schoppe, Fritz, Dipl.-Ing.
(86) Internationale Anmeldenummer: EP9700375
(87) Internationale Veröffentlichungsnummer: WO9735382

(56) Entgegenhaltungen:
- EP-A- 0 461 358
- EP-A- 0 476 605
- GB-A- 2 007 445
- US-A- 4 849 663
- US-A- 5 175 729
- US-A- 5 461 344

## Beschreibung

Die vorliegende Erfindung betrifft Phasenregelschleifen und insbesondere solche Phasenregelschleifen, die eine umschaltbare Schleifenbandbreite aufweisen.

Das technische Anwendungsgebiet von Phasenregelschleifen mit umschaltbarer Schleifenbandbreite liegt hauptsächlich im Bereich von Funksystemen, die TDMA-Verfahren (TDMA = Time Division Multiple Access = Mehrfachzugriff im Zeitmultiplex) verwenden, und bei denen ein schnelles Umschalten des Frequenzkanals erforderlich ist. Auch bei der Anwendung des sogenannten Frequenzsprungverfahrens (Frequency Hopping), typischerweise bei drahtlosen lokalen Netzen, kann ein derartiger Synthesizer vorteilhaft eingesetzt werden.

Wenn der spannungsgesteuerte Oszillator (VCO; VCO = Voltage Controlled Oszillator) eines solchen Synthesizers direkt moduliert wird, ist es erforderlich, die Schleifenbandbreite der Phasenregelschleife (PLL; PLL = Phase Locked Loop) um eine Größenordnung kleiner zu machen als die niedrigste Modulationsfrequenz. Für einen schnellen Wechsel des Frequenzkanals ist es dagegen notwendig, eine möglichst große Schleifenbandbreite bereitzustellen, um ein schnelles Einschwingen des VCO auf die Soll-Frequenz zu erzwingen.

Aus dem Artikel "A Fast Locking Scheme for PLL Frequency Synthesizers" von David Byrd u.a., Proceedings of the Third Annual WIRELESS Symposium, 13.-17. Februar 1995, Santa Clara Convention Center, Santa Clara, CA, Seiten 96 - 100, ist eine Phasenregelschleife mit einer umschaltbaren Schleifenbandbreite bekannt. Die bekannte Vorrichtung besteht aus einer Phasenregelschleife, bei der den Widerstand eines Schleifenfilters durch das Zuschalten eines Parallelwiderstands umschaltbar ist. Ferner ist bei der bekannten Vorrichtung der Phasendetektorstrom auf einen vierfachen Stromwert umschaltbar. Nachteilig bei der bekannten Vorrichtung ist, daß gleichzeitig mit dem Umschalten des Widerstands des Schleifenfilters auch der Phasendetektorstrom umgeschaltet werden muß. Da der Phasendetektorstrom quadratisch mit der Schleifenbandbreite der Phasenregelschleife erhöht werden muß, ist das Verhältnis, in dem die Schleifenbandbreite umgeschaltet werden kann, relativ eingeschränkt. Der Dynamikbereich eines Phasendetektors liegt größenordnungsmäßig bei 100, was ein Umschalten der Schleifenbandbreite in einem Verhältnis 1:10 ermöglicht. Dieses Verhältnis ist beispielsweise für eine Anwendung im DECT-Standard (DECT = Digital European Cordless Telecommunication = Europäischer Drahtlos-Standard für die Telekommunikation) bei weitem nicht ausreichend. Das erforderliche Verhältnis beim DECT-Standard liegt bei etwa 1:100, was eine Dynamik des Phasendetektors von 1:10.000 erfordern würde.

Alternativ können zum Umschalten der Schleifenbandbreite aktive Schleifenfilter verwendet werden. Aktive Schleifenfilter weisen jedoch grundsätzlich ein höheres Rauschen auf und sind mit einem erhöhten Bauteilaufwand und Stromverbrauch verbunden.

Die DE 19534516A1 zeigt einen Phasenregelkreis, der eine einstellbare Bandbreite hat. Eingänge eines Phasendetektors sind einerseits ein frequenzmäßig geteiltes Ausgangssignal des Phasenregelkreises und andererseits eine Referenzfrequenz. Mit dem Ausgang des Phasendetektors ist ein Schleifenfilter verbunden. Mit dem Ausgangssignal des Schleifenfilters wird die Bandbreite eines spannungsgesteuerten Oszillators gesteuert. Mit dem Ausgang des Phasendetektors ist eine Einrastüberwachungsschaltung verbunden, die Impulse des Ausgangssignals des Phasendetektors mit einem Referenzfenster vergleicht und mittelt, wodurch ein zweites Steuersignal gebildet wird, durch das das Schleifenfilter in einen schmalbandigen Zustand gesteuert werden kann. Dieser Phasenregelkreis erfordert ein Schleifenfilter, bei dem nötigerweise immer aktive Bauelemente im Signalweg liegen. Durch diese aktiven Bauelemente wird ein 1/f-Rauschen erzeugt, das insbesondere im Fall von spannungsgesteuerten Oszillatoren mit hoher Abstimmsteilheit zu einer nennenswerten Verschlechterung des Phasenrauschens führt.

Die JP 07-283724A zeigt einen Phasenregelkreis mit einem ersten Schleifenfilter, das mit dem Ausgang eines Phasenkomparators verbunden ist, dem eine Spannungsfolgerschaltung aus zwei Transistoren in Kollektorschaltung folgt, welcher wiederum ein zweites Schleifenfilter folgt, das mit dem Steuereingang eines spannungsgesteuerten Oszillators verbunden ist. Das zweite Schleifenfilter wird durch ein R₃C₂-Tiefpaßfilter gebildet, wobei die Durchtrittsfrequenz des Regelkreises im eingeschwungenen Zustand auf einen sehr niedrigen Wert gelegt werden kann, indem der Widerstandswert R3 sehr groß gewählt wird. Dies führt tatsächlich dazu, daß das Ausqangssignal dieses Phasenregelkreises relativ rauscharm ist. Sobald aber der angeschlossene spannungsgesteuerte Oszillator gegen die Schleife moduliert wird, was z.B. bei DECT-Systemen geschieht, regelt die phasenstarre Regelschleife die Modulation aus, was völlig unerwünscht ist. Ferner muß bei dieser bekannten Phasenregelschleife als nachteilig angesehen werden, daß die Schleifenverstärkung durch die Nichtlinearität der Transistoren unberechenbar wird, so daß das Verhalten der Schleife beim Einschwingen schwer vorhersehbar ist. Ferner bringen die Bipolartransistoren durch ihre Emitterströme ständig eine Störung in den Regelkreis ein.

Die JP 06-326602A zeigt eine weitere Phasenregelschleife, bei der zwei Tiefpaßfilter direkt hintereinander geschaltet sind. Die Hintereinanderschaltung der beiden Tiefpaßfilter führt zu einem Spannungsstoß beim Umschalten der Filter, was bei einer Phasenregelschleife zur Erzeugung einer stabilen Oszillatorfrequenz völlig unerwünscht ist. Außerdem erscheint bei dieser bekannten Phasenregelschleife immer dann, wenn die Schalter geöffnet sind, die Regelschleife aufgetrennt. Die Frequenz des spannungsgesteuerten Oszillators ist damit nicht stabilisiert, was mit all jenen negativen Folgen einhergeht, die auch von einigen DECT-Systemen her bekannt sind.

Bei der Schaltung nach der Entgegenhaltung JP 05-259902A wird nur ein Schleifenfilter verwendet, dessen Eigenschaften durch Hinzu- und Wegschalten eines Kondensators verändert wird. Diese bekannte Schaltung kombiniert gleich mehrere Probleme miteinander. Durch die unvermeidliche Offsetspannung im Verstärker führt ein Umschalten des Schalters 56 immer zu einem unerwünschten Spannungssprung, der mit hoher Bandbreite den spannungsgesteuerten Oszillator moduliert.

Die EP-A-0476605 zeigt eine Phasenregelschleifenschaltung, die ein erstes Schleifenfilter und ein Hilfsschleifenfilter aufweist. Das Hilfsschleifenfilter besteht aus einer aktiven Filterschaltung und einer invertierenden Verstärkerschaltung. Während eines Phasenregelmodus wird das Hilfsschleifenfilter mittels zweier Schalter in die Phasenregelschleifenschaltung zugeschaltet. Hierbei verbindet der erste Schalter den Verbindungspunkt zwischen Ladungspumpe und erstem Schleifenfilter mit dem Eingang des Hilfsschleifenfilters. Der zweite Schalter verbindet den Ausgang des Hilfsschleifenfilters mit dem Verbindungspunkt der Serienschaltung aus Widerstand und Kondensator des Schleifenfilters. Das Hilfsschleifenfilter dient dazu, während eines Phasenregelbetriebs eine Beladungsdauer und eine Entladungsdauer des Kondensators des Schleifenfilters zu reduzieren.

Die US-A-5461344 betrifft einen Phasenregelschleifen-Frequenzsynthetisierer, der einen spannungsgesteuerten Oszillator, einen Referenzoszillator, eine Frequenzteilerschaltung, eine Phasendetektorschaltung und zwei Schleifenfilterschaltungen aufweist. Diese bekannte Vorrichtung dient dazu, ein schnelles Einschwingen des PLL-Synthetisierers auf eine neue Ausgangsfrequenz zu erreichen. Dazu wird für den Umschaltvorgang die Phasenvergleichsfrequenz am Phasendetektor erhöht. Da die Einschwingzeit abhängig von der Phasenvergleichsfrequenz ist, läßt sich so ein schnelleres Einschwingen auf die neue Frequenz erreichen.

Die US-A-5175729 betrifft eine Phasenregelschleife für ein Kommunikationsgerät, die eine erstes breitbandiges und ein zweites schmalbandiges Filter aufweist. Eine Umschaltvorrichtung ist vorgesehen, um eines der Filter mit dem spannungsgesteuerten Oszillator der Phasenregelschleife zu verbinden.

Ausgehend von dem genannten Stand der Technik besteht die Aufgabe der vorliegenden Erfindung darin, eine Phasenregelschleife zu schaffen, deren Schleifenbandbreite in einem Verhältnis von 1:100 und mehr umgeschaltet werden kann und deren Phasendetektorstrom zum Umschalten der Schleifenbandbreite nicht umgeschaltet werden muß und die ferner einen geringen Bauteilaufwand und Stromverbrauch aufweist.

Diese Aufgabe wird durch eine Phasenregelschleife mit umschaltbarer Schleifenbandbreite gemäß Patentanspruch 1 gelöst.

Die Phasenregelschleife gemäß der vorliegenden Erfindung ermöglicht das Umschalten der Schleifenbandbreite unter Verwendung eines gewöhnlichen Phasendetektors und zweier passiver Schleifenfilter um den Faktor 100 oder mehr. Dabei muß der Phasendetektorstrom nicht umgeschaltet werden. Trotz der hohen Schleifenbandbreite während des Einschwingens, die durch die erste Schleifenfilterschaltung realisiert ist, kann der Synthesizer im eingeschwungenen Zustand mit einer guten Unterdrückung der Referenzlinien betrieben werden, da die Schleifenbandbreite, die durch die zweite Schleifenfilterschaltung festgelegt ist, dann niedriger ist.

Mit einer Phasenregelschleife gemäß der vorliegenden Erfindung läßt sich der DECT-Standard ohne Einschränkungen, d.h. beispielsweise ohne Blind-Slots usw., mit einer handelsüblichen Einschleifen-Phasenregelschleife realisieren. Bei der Phasenregelschleife gemäß der vorliegenden Erfindung ist kein zweiter Synthesizer erforderlich. Ferner lassen sich schnell einschwingende, einfache Synthesizer mit einer guten Unterdrückung der Referenzlinien realisieren.

Gemäß der vorliegenden Erfindung ist zum schnellen Einschwingen der Phasenregelschleife nach einem Frequenzwechsel ein passives Schleifenfilter mit einer hohen Durchtrittsfrequenz verwendet, welches vorzugsweise durch einen RC-Tiefpaß realisiert ist. Die Spannungen an den Kondensatoren eines zweiten Schleifenfilters mit einer niedrigeren Durchtrittsfrequenz, das ebenfalls vorzugsweise ein RC-Tiefpaß ist, werden durch Spannungsfolger an die des schnellen Schleifenfilters angebunden. Das langsame Filter, d.h., das Filter mit der niedrigeren Durchtrittsfrequenz, verhält sich somit genau wie das schnelle Filter, d.h., das Filter mit der hohen Durchtrittsfrequenz. Die Schleife arbeitet mit einer kurzen Einschwingzeit. Ist nun ein neuer Frequenzkanal eingestellt, so schaltet man auf das langsame Filter um. Die Grenzfrequenz der Schleife ist danach so niedrig eingestellt, daß der spannungsgesteuerte Oszillator (VCO) frequenzmoduliert werden kann, um die Daten zum Empfänger zu übertragen. Das schnelle Schleifenfilter ist aufgrund seiner hohen Impedanz nicht mehr relevant für das Verhalten der Regelschleife. Die Unterdrückung der Referenzlinien der Phasenregelschleife im Ausgangssignal des VCO ist durch die niedrige Grenzfrequenz der Phasenregelschleife verbessert. Ferner ist ein Umschalten zwischen beiden Filtern im eingeschwungenen Zustand ohne Störung der Phasenregelschleife (PLL) möglich.

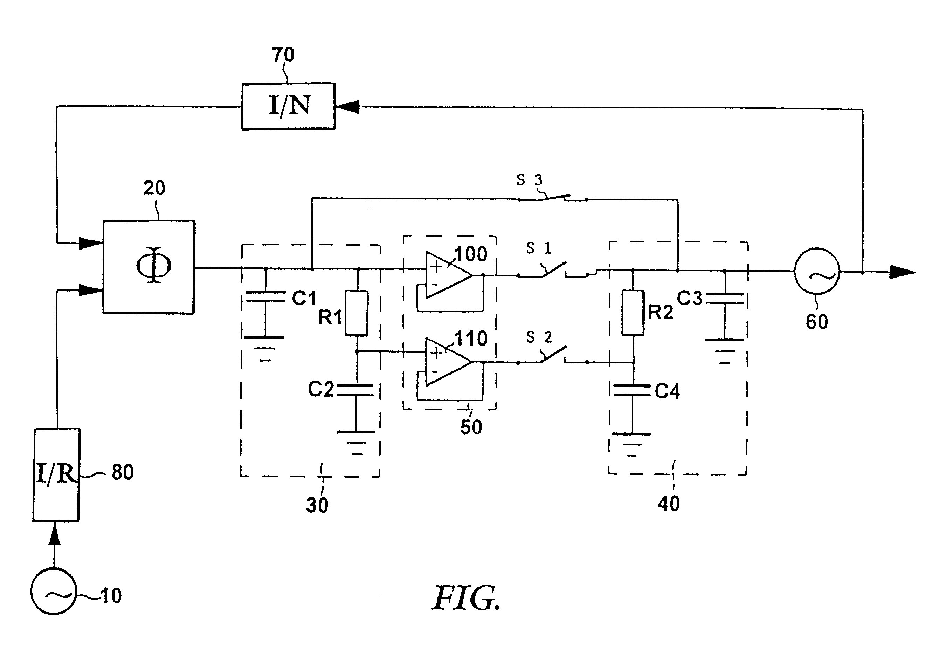

Ein bevorzugtes Ausführungsbeispiel der vorliegenden Erfindung wird nachfolgend bezugnehmend auf die beiliegende Zeichnung näher erläutert.

Die einzige Figur zeigt ein Schaltungsdiagramm einer Phasenregelschleife mit umschaltbarer Schleifenbandbreite gemäß dem bevorzugten Ausführungsbeispiel der vorliegenden Erfindung.

Die Phasenregelschleife weist eine Referenzfrequenzquelle 10, beispielsweise einen Quarzoszillator, eine Phasendetektorschaltung 20, eine erste und eine zweite Schleifenfilterschaltung 30, 40, eine Spannungsfolgerschaltung 50, eine Umschalteinrichtung, einen spannungsgesteuerten Oszillator 60 und einen Rückkopplungszweig von dem Ausgang des spannungsgesteuerten Oszillators 60 über einen Frequenzteiler 70 zu einem Eingang des Phasendetektors 20 auf. Der Oszillator 10 ist vorzugsweise über einen Referenzfrequenzteiler 80 mit einem weiteren Eingang der Phasendetektorschaltung 20 verbunden.

Bei der Phasenregelschleife gemäß dem bevorzugten Ausführungsbeispiel der vorliegenden Erfindung ist das Schleifenfilter einer herkömmlichen Phasenregelschleife durch die erste Schleifenfilterschaltung 30, die zweite Schleifenfilterschaltung 40, die Spannungsfolgerschaltung 50 sowie die Umschalteinrichtung ersetzt.

Das Referenzfrequenzsignal von dem Quarzoszillator 10 wird mittels des Referenzfrequenzteilers 80 durch R geteilt und einem Eingang des Phasendetektors 20 zugeführt, in dem dasselbe mit dem Ausgangssignal des VCO-Oszillators, das durch den Frequenzteiler 70 durch N geteilt wird, verglichen wird.

Die Phasendetektorschaltung 20 besteht bei dem bevorzugten Ausführungsbeispiel aus einem Phasendetektor und einer Strommodus-Ladungspumpe, die auf der Basis des Ergebnisses des Vergleichs der Referenzfrequenz und der VCO-Frequenz einen Strom liefert. Dieser Strom wird in den Schleifenfilterschaltungen in die Steuerspannung des VCOs umgewandelt. Die Funktion dieser Phasenregelschleife besteht darin, die Spannung, die dem VCO geliefert wird, einzustellen, bis die durch N geteilte Frequenz des Rückkopplungssignals mit der durch R geteilten Frequenz des Referenzsignals übereinstimmt.

Gemäß der vorliegenden Erfindung ist der Ausgang des Phasendetektors 20 mit einer ersten Schleifenfilterschaltung 30 verbunden. Die Schleifenfilterschaltung 30 ist über die Spannungsfolgerschaltung 50 sowie die Umschalteinrichtung, die aus drei Schaltern S1, S2 und S3 besteht, mit der zweiten Schleifenfilterschaltung 40 verbunden. Der Ausgang der zweiten Schleifenfilterschaltung 40 ist mit dem spannungsgesteuerten Oszillator 60 verbunden.

Die erste Schleifenfilterschaltung 30 besteht aus einer Parallelschaltung, die aus einem Kondensator C1 und einer Reihenschaltung eines Kondensators C2 und eines Widerstands R1 besteht. Die Werte dieser Schaltungselemente sind gewählt, um eine hohe Grenzfrequenz, beispielsweise 110 Kilohertz, dieses Tiefpaßfilters zu liefern. Die oben genannte Parallelschaltung, die im folgenden mit erste Parallelschaltung bezeichnet wird, ist zwischen den Ausgang der Phasendetektorschaltung 20 und ein Massepotential geschaltet. Der Verbindungspunkt der ersten Parallelschaltung und der Phasendetektorschaltung 20 ist über einen Spannungsfolger 100 mit einem Ende des Schalters S1 der Umschalteinrichtung verbunden. Der Verbindungspunkt zwischen dem Widerstand R1 und dem Kondensator C2 ist über einen zweiten Spannungsfolger 110 mit einem Ende des Schalters S2 der Umschalteinrichtung verbunden.

Die zweite Schleifenfilterschaltung 40 besteht ebenfalls aus einer Parallelschaltung, die aus einem Kondensator C3 und der Reihenschaltung eines Kondensators C4 und eines Widerstands R2 besteht. Diese Parallelschaltung wird im folgenden als zweite Parallelschaltung bezeichnet und ist zwischen einen Steuereingang des spannungsgesteuerten Oszillators 60 und ein Massepotential geschaltet. Die Werte der Elemente der zweiten Schleifenfilterschaltung sind eingestellt, um eine niedrige Grenzfrequenz, beispielsweise 1 Kilohertz, dieses zweiten Tiefpaßfilters zu liefern.

Das zweite Ende des Schalters S1 ist mit dem Verbindungspunkt zwischen dem Steuereingang des VCOs 60 und der zweiten Parallelschaltung verbunden. Das zweite Ende des Schalters S2 ist mit dem Verbindungspunkt zwischen dem Widerstand R2 und dem Kondensator C4 verbunden. Ferner ist der Verbindungspunkt zwischen der Phasendetektorschaltung 20 und der ersten Parallelschaltung über den Schalter S3 der Umschalteinrichtung direkt mit dem Verbindungspunkt zwischen dem Steuereingang des VCOs und der zweiten Parallelschaltung verbindbar.

Bei einem Frequenzwechsel sind bei der oben beschriebenen Phasenregelschleife gemäß dem bevorzugten Ausführungsbeispiel der vorliegenden Erfindung die Schalter S1 und S2 geschlossen, während der Schalter S3 geöffnet ist. Dadurch sind die Spannungen an den Kondensatoren C3 und C4 durch die Spannungsfolger 100 und 110 an die Spannungen an den Kondensatoren C1 und C2 der ersten Schleifenfilterschaltung 30 angebunden. Die Spannungsfolger bestehen bei dem bevorzugten Ausführungsbeispiel der Erfindung jeweils aus einem Operationsverstärker, dessen Ausgang mit dem invertierenden Eingang desselben verbunden ist. Die Schleifenfilterschaltung 40 hat somit keine Auswirkung auf die Steuerspannung des VCOs. Somit ist nur die erste Schleifenfilterschaltung mit der hohen Schleifenbandbreite wirksam, weshalb die Schleife mit einer kurzen Einschwingzeit arbeitet.

Nach dem Einschwingen, beispielsweise nach 45 Mikrosekunden, wird der Schalter S3 geschlossen, während die Schalter S1 und S2 geöffnet werden. Die Schleifenfilterschaltungen 30 und 40 sind nunmehr über den Schalter S3 seriell verbunden. Dadurch ist die niedrige Grenzfrequenz der zweiten Schleifenfilterschaltung 40 wirksam. Dadurch bedingt ist die Grenzfrequenz der Schleife so niedrig, daß der VCO frequenzmoduliert werden kann, um Daten zu einem Empfänger zu übertragen.

Das bevorzugte Ausführungsbeispiel ist auch betreibbar, wenn der zweite Spannungsfolger 110 und der Schalter S2 der Umschaltungseinrichtung fehlen. In diesem Fall ist jedoch das Verhalten der Schaltung verschlechtert, da der Kondensator C4 der Schleifenfilterschaltung 40 über den Schalter S1 geladen werden muß.

Neben den bezüglich des bevorzugten Ausführungsbeispiels beschriebenen Filteranordnungen sind gemäß der vorliegenden Erfindung beliebige mehrstufige Filtereinrichtungen verwendbar. Das beste Verhalten wäre dann zu erreichen, wenn jedes ladungsspeichernde Element des jeweils ersten Filters über einen Spannungsfolger mit dem jeweiligen ladungsspeichernden Element des zweiten Schleifenfilters verbunden wäre. Unter Hinnahme bestimmter Verhaltensnachteile reicht es in einem solchen Fall jedoch aus, nur ausgewählte Ladungsspeicherelemente über Spannungsfolger miteinander zu verbinden.

Die vorliegende Erfindung ermöglicht es konkret, die hohen Anforderungen des DECT-Standards an die Umschaltzeiten der Frequenzkanäle zu erfüllen. In diesen Anforderungen wird gefordert, daß der Frequenzsynthesizer einen Kanalwechsel, bzw. die Sende/Empfangsumschaltung, innerhalb der sogenannten Sperrzeit (guard time) zwischen zwei TDMA-Slots ausführen kann. Für einen Kanalwechsel stehen somit maximal 50 Mikrosekunden zur Verfügung. Maximal muß der Synthesizer bei einem Superheterodynempfänger mit einer Zwischenfrequenz von 110,592 Megahertz einen Sprung über 208 Megahertz ausführen. Bei einem Ausführungsbeispiel der vorliegenden Erfindung erfolgt die Umschaltung auf das langsame Schleifenfilter, d.h. das Schleifenfilter mit der niedrigen Grenzfrequenz, nach ca. 45 Mikrosekunden. Dabei wird die Schleifenbandbreite von ca. 110 Kilohertz auf ca. 1 Kilohertz reduziert.

Die vorliegende Erfindung schafft somit eine Phasenregelschleife mit umschaltbarer Schleifenbandbreite, mittels derer sich der DECT-Standard ohne Einschränkungen mit einer handelsüblichen Einschleifen-PLL realisieren läßt. Dabei ist ein zweiter Synthesizer nicht erforderlich. Ferner lassen sich schnell einschwingende, einfache Synthesizer mit einer guten Unterdrückung der Referenzlinien realisieren.

## Patentansprüche

1. Phasenregelschleife mit umschaltbarer hoher oder niedriger Schleifenbandbreite mit folgenden Merkmalen:
einem spannungsgesteuerten Oszillator (60) mit einem Steuereingang zum Anlegen einer Steuerspannung;
einer Referenzfrequenzquelle (10);
einer Frequenzteilerschaltung (70), die mit dem Ausgang des spannungsgesteuerten Oszillators (60) verbunden ist;
einer Phasendetektorschaltung (20), die mit der Referenzfrequenzquelle (10) und der Frequenzteilerschaltung (70) verbunden ist;
einer ersten Schleifenfilterschaltung (30), die die hohe Schleifenbandbreite festlegt und die mit dem Ausgang der Phasendetektorschaltung (20) verbunden ist;
einer zweiten Schleifenfilterschaltung (40), die die niedrige Schleifenbandbreite festlegt, deren Ausgang mit dem Steuereingang des spannungsgesteuerten Oszillators (60) verbunden ist;
einer Spannungsfolgerschaltung (50); und
einerUmschalteinrichtung(S1, S2, S3),
dadurch gekennzeichnet,
daß die Umschalteinrichtung (S1, S2, S3) in einem ersten Schaltzustand zur Festlegung der hohen Schleifenbandbreite die Spannungsfolgerschaltung (50) derart zwischen die beiden Schleifenfilterschaltungen (30, 40) schaltet, daß Schaltungselemente des zweiten Schleifenfilters (40) derart an Schaltungselemente des ersten Schleifenfilters (30) angekoppelt sind, daß das zweite Schleifenfilter keine Auswirkungen auf die Steuerspannung des spannungsgesteuerten Oszillators (60) hat; und
daß die Umschalteinrichtung (S1, S2, S3) in einem zweiten Schaltzustand zur Festlegung der niedrigen Schleifenbandbreite die Spannungsfolgerschaltung (50) von zumindest einer der Schleifenfilterschaltungen (30, 40) trennt und die Schleifenfilterschaltungen (30, 40) seriell verbindet, derart, daß die niedrige Schleifenbandbreite des zweiten Schleifenfilters (40) wirksam ist, um das Steuersignal des spannungsgesteuerten Oszillators (60) einzustellen.

2. Phasenregelschleife gemäß Anspruch 1, bei der zwischen die Referenzfrequenzquelle (10) und die Phasendetektorschaltung (20) eine Referenzfrequenzteilerschaltung (80) geschaltet ist.

3. Phasenregelschleife gemäß Anspruch 1 oder 2, bei der die Schleifenfilterschaltungen (30, 40) RC-Tiefpaßfilter sind.

4. Phasenregelschleife gemäß einem der Ansprüche 1 bis 3, bei der die Phasendetektorschaltung (20) einen Phasendetektor und eine Strommodus-Ladungspumpe aufweist.

5. Phasenregelschleife gemäß Anspruch 4, bei der die erste Schleifenfilterschaltung (30) aus einer ersten Parallelschaltung eines ersten Kondensators (C1) und einer Reihenschaltung eines zweiten Kondensators (C2) und eines ersten Widerstands (R1) besteht, wobei die erste Parallelschaltung zwischen den Ausgang der Phasendetektorschaltung (20) und ein Massepotential geschaltet ist, und bei der die zweite Schleifenfilterschaltung (40) aus einer zweiten Parallelschaltung aus einem dritten Kondensator (C3) und einer Reihenschaltung eines vierten Kondensators (C4) und eines zweiten Widerstands (R2) besteht, wobei die zweite Parallelschaltung zwischen dem Steuereingang des spannungsgesteuerten Oszillators (60) und das Massepotential geschaltet ist.

6. Phasenregelschleife gemäß Anspruch 5, bei der die Spannungsfolgerschaltung (50) einen ersten (100) und einen zweiten (110) Spannungsfolger aufweist, und bei der die Umschalteinrichtung einen ersten (S1), einen zweiten (S2) und einen dritten (S3) Schalter aufweist, wobei der erste Spannungsfolger (100) mittels des ersten Schalters (S1) zwischen den Verbindungspunkt zwischen der Phasendetektorschaltung (20) und der ersten Parallelschaltung und den Verbindungspunkt zwischen dem Steuereingang des spannungsgesteuerten Oszillators (60) und der zweiten Parallelschaltung schaltbar ist, und wobei der zweite Spannungsfolger (110) mittels des zweiten Schalters (S2) zwischen den Verbindungspunkt zwischen dem zweiten Kondensator (C2) und dem ersten Widerstand (R1) und den Verbindungspunkt zwischen dem vierten Kondensator (C4) und dem zweiten Widerstand (R2) schaltbar ist, und wobei der Verbindungspunkt zwischen der Phasendetektorschaltung (20) und der ersten Parallelschaltung mit dem Verbindungspunkt zwischen dem Steuereingang des spannungsgesteuerten Oszillators (60) und der zweiten Parallelschaltung mittels des dritten Schalters (53) direkt verbindbar ist.

## Claims

1. A phase-locked loop switchable between a high and a low loop bandwidth with the following features:
a voltage-controlled oscillator (60) with a control input for applying a control voltage;
a reference frequency source (10);
a frequency divider circuit (70), which is connected to the output of the voltage-controlled oscillator (60);
a phase detector circuit (20), which is connected to the reference frequency source (10) and the frequency divider circuit (70);
a first loop filter circuit (30), which defines the high loop bandwidth and which is connected to the output of the phase detector circuit (20);
a second loop filter circuit (40), which defines the low loop bandwidth and the output of which is connected to the control input of the voltage-controlled oscillator (60);
a voltage follower circuit (50); and
a switching means (S1, S2, S3),
characterized in
that the switching means (S1, S2, S3) in a first switching state for determining the high loop bandwidth switches the voltage follower circuit (50) between the two loop filter circuits (30, 40) in such a way that circuit elements of the second loop filter circuit (40) are coupled to circuit elements of the first loop filter circuit (30) in such a way that the second loop filter circuit has no effect on the control voltage of the voltage-controlled oscillator (60); and
that the switching means (S1, S2, S3) in a second switching state for determining the low loop bandwidth disconnects the voltage follower circuit (50) from at least one of the loop filter circuits (30, 40) and connects the loop filter circuits (30, 40) in series in such a way that the low loop bandwidth of the second loop filter circuit (40) is effective in setting the control signal of the voltage-controlled oscillator (60).

2. A phase-locked loop according to claim 1, wherein a reference frequency divider circuit (80) is circuited between the reference frequency source (10) and the phase detector circuit (20).

3. A phase-locked loop according to claim 1 or 2, wherein the loop filter circuits (30, 40) are RC low-pass filters.

4. A phase-locked loop according to one of the claims 1 to 3, wherein the phase detector circuit (20) comprises a phase detector and a current-mode charge pump.

5. A phase-locked loop according to claim 4, wherein the first loop filter circuit (30) consists of a first parallel circuit comprising a first capacitor (C1) and a second capacitor (C2) and first resistor (R1) connected in series, the first parallel circuit being circuited between the output of the phase detector circuit (20) and ground potential, and wherein the second loop filter circuit (40) consists of a second parallel circuit comprising a third capacitor (C3) and a fourth capacitor (C4) and second resistor (R2) connected in series, the second parallel circuit being circuited between the control input of the voltage-controlled oscillator (60) and ground potential.

6. A phase-locked loop according to claim 5, wherein the voltage follower circuit (50) comprises a first (100) and a second (110) voltage follower, and wherein the switching means comprises a first (S1), a second (S2) and a third (S3) switch, where the first voltage follower (100) is switchable, via the first switch (S1), between the connection point between the phase detector circuit (20) and the first parallel circuit and the connection point between the control input of the voltage-controlled oscillator (60) and the second parallel circuit, and where the second voltage follower (110) is switchable, via the second switch (S2), between the connection point between the second capacitor (C2) and the first resistor (R1) and the connection point between the fourth capacitor (C4) and the second resistor (R2), and where the connection point between the phase detector circuit (20) and the first parallel circuit is directly connectable, via the third switch (S3), to the connection point between the control input of the voltage-controlled oscillator (60) and the second parallel circuit.

## Revendications

1. Boucle à asservissement de phase à grande ou faible largeur de bande de boucle commutable, aux caractéristiques suivantes :
un oscillateur commandé par tension (60) avec une entrée de commande pour l'application d'une tension de commande ;
une source de fréquence de référence (10) ;
un circuit diviseur de fréquence (70) relié à la sortie de l'oscillateur commandé par tension (60) ;
un circuit détecteur de phase (20) relié à la source de fréquence de référence (10) et au circuit diviseur de fréquence (70) ;
un premier circuit de filtre à boucle (30) fixant la grande largeur de bande de boucle et relié à la sortie du circuit détecteur de phase (20) ;
un second circuit de filtre à boucle (40) fixant la faible largeur de bande de boucle, dont la sortie est reliée à l'entrée de commande de l'oscillateur commandé par tension (60) ;
un circuit suiveur de tension (50) ; et
un dispositif de commutation (S1, S2, S3),
caractérisée par le fait
que le dispositif de commutation (S1, S2, S3) commute, dans un premier état de commutation pour fixer la grande largeur de bande de boucle, le circuit suiveur de tension (50) entre les deux circuits de filtre à boucle (30, 40) de telle sorte que des éléments de commutation du second filtre à boucle (40) soient couplés à des éléments de commutation du premier filtre à boucle (30), de sorte que le second filtre à boucle n'a pas d'effets sur la tension de commande de l'oscillateur commandé par tension (60), et
que le dispositif de commutation (S1, S2, S3) déconnecte, dans un second état de commutation pour fixer la faible largeur de bande de boucle, le circuit suiveur de tension (50) d'au moins l'un des circuits de filtre à boucle (30, 40) et relie en série les circuits de filtre à boucle (30, 40), de sorte que la faible largeur de bande de boucle du second filtre à boucle (40) est active, pour régler le signal de commande de l'oscillateur commandé par tension (60).

2. Boucle à asservissement de phase suivant la revendication 1, dans laquelle un circuit diviseur de fréquence de référence (80) est connecté entre la source de fréquence de référence (10) et le circuit détecteur de phase (20).

3. Boucle à asservissement de phase suivant la revendication 1 ou 2, dans laquelle les circuits de filtre à boucle (30, 40) sont des filtres passe-bas RC.

4. Boucle à asservissement de phase suivant l'une des revendications 1 à 3, dans laquelle le circuit détecteur de phase (20) présente un détecteur de phase et une pompe de chargement de mode de courant.

5. Boucle à asservissement de phase selon la revendication 4, dans laquelle le premier circuit de filtre à boucle (30) est composé d'un premier circuit en parallèle composé d'un premier condensateur (C1) et d'une connexion en série d'un second condensateur (C2) et d'une première résistance (R1), le premier circuit en parallèle étant connecté entre la sortie du circuit détecteur de phase (20) et un potentiel de masse et dans laquelle le second circuit de filtre à boucle (40) est composé d'un second circuit en parallèle composé d'un troisième condensateur (C3) et d'une connexion en série d'un quatrième condensateur (C4) et d'une seconde résistance (R2), le second circuit en parallèle étant connecté entre l'entrée de commande de l'oscillateur commandé par tension (60) et le potentiel de masse.

6. Boucle à asservissement de phase selon la revendication 5, dans laquelle le circuit suiveur de tension (50) présente un premier (100) et un second (110) suiveur de tension et dans laquelle le dispositif de commutation présente un premier (S1), un second (S2) et un troisième (S3) interrupteur, le premier suiveur de tension (100) pouvant être commuté, à l'aide du premier interrupteur (S1), entre le point de connexion entre le circuit détecteur de phase (20) et le premier circuit en parallèle et le point de connexion entre l'entrée de commande de l'oscillateur commandé par tension (60) et le second circuit en parallèle, et le second suiveur de tension (110) pouvant être commuté, à l'aide du second interrupteur (S2), entre le point de connexion entre le second condensateur (C2) et la première résistance (Rl) et le point de connexion entre le quatrième condensateur (C4) et la seconde résistance (R2), et le point de connexion entre le circuit détecteur de phase (20) et le premier circuit en parallèle pouvant être relié directement, à l'aide du troisième intgerrupteur (S3), au point de connexion entre l'entrée de commande de l'oscillateur commandé par tension (60) et le second circuit en parallèle
